# EUROPEAN PATENT SPECIFICATION

(11) **EP 4 145 497 B1**
(45) Date of publication and mention of the grant of the patent: **25.11.2026**
(21) Application number: 22194033.1
(22) Date of filing: 06.09.2022
(51) Int. Cl.: H10W 20/00, H10W 20/40, H10W 20/41

(54) **SEMICONDUCTOR DEVICE AND PREPARATION METHOD THEREOF**
HALBLEITERBAUELEMENT UND HERSTELLUNGSVERFAHREN DAFÜR
DISPOSITIF À SEMI-CONDUCTEUR ET SON PROCÉDÉ DE PRÉPARATION

(30) Priority: 07.09.2021 CN 202111044516
(43) Date of publication of application: 08.03.2023
(73) Proprietor: Huawei Technologies Co., Ltd., Shenzhen, Guangdong 518129, (CN)
(72) Inventor: YANG, Chengxin, Shenzhen, 518129 (CN); SUN, Hui, Shenzhen, 518129 (CN); ZENG, Wei, Shenzhen, 518129 (CN); YANG, Gangyi, Shenzhen, 518129 (CN)
(74) Representative: Körber, Martin Hans

(56) References cited:
- US-A1- 2015 340 314
- US-A1- 2018 337 093
- US-B1- 9 991 373

## Description

### TECHNICAL FIELD

This application relates to the field of semiconductor technologies, and in particular, to a semiconductor device and a preparation method thereof.

### BACKGROUND

A wide bandgap semiconductor gallium nitride (GaN) is characterized by a high breakdown electric field, high electron mobility, and a high electron saturation drift velocity, and has wide application prospect in the fields of power electronics and radio frequency microwave. Piezoelectric polarization and spontaneous polarization that are caused by aluminum gallium nitride (AlGaN)/GaN result in formation of high-concentration two-dimensional electron gas at a heterojunction interface, and mobility and a saturation velocity of AlGaN/GaN are far higher than those of silicon. A high electron mobility transistor (HEMT) made by using an AlGaN/GaN heterojunction as a core has excellent performance, and is very suitable for making a power semiconductor device. Currently, this is a matter of wide concern in the industry.

In some semiconductor devices, a through gallium nitride via (TGV) process needs to be added to avoid damage to a device structure due to a large stress in a packaging cutting process of a wafer. This process is usually performed after the last metal process. In the TGV process, both a dielectric layer and an epitaxial layer need to be penetrated through etching, and the etching stops at a substrate. Currently, to meet different packaging technology requirements, such as wafer level chip scale package (WLCSP) or embedded component package (ECP), a TGV process needs to be performed before the last metal process, to dispose metal in a TGV, thereby facilitating subsequent packaging wiring leading-out.

However, in a conventional preparation manner, a tungsten plug has relatively poor morphology and quality, and it is prone to remain photoresist and other substances when a TGV process is implemented, resulting in an increase in a contact resistance of a through via in which the tungsten plug is located, affecting overall performance of a device.

### SUMMARY

This application provides a semiconductor device and a preparation method thereof, to prevent performance of the device from being affected due to an increase in a resistance in a through via in a TGV process.

According to a first aspect, this application provides a semiconductor device, such as an HEMT. The semiconductor device has a through gallium nitride via TGV. Specifically, the semiconductor device has a first region and a second region, and the TGV is disposed in the second region. The semiconductor device specifically includes a substrate, and an epitaxial layer, a first dielectric layer, a first metal layer, a second dielectric layer, a protective layer, and a second metal layer that are sequentially laminated on the substrate. The first metal layer is located in the first region, the second dielectric layer has through vias that penetrate through the second dielectric layer to connect the first metal layer and the protective layer, a connecting material is filled in the through via to form a connecting piece, and the connecting piece can connect the first metal layer and the second metal layer to implement a function of the device, wherein the protective layer covers a surface of the connecting piece. The TGV penetrates through the protective layer, the second dielectric layer, the first dielectric layer, and the epitaxial layer to the substrate. It is equivalent that the substrate can be exposed from a bottom of the TGV. The second metal layer covers the protective layer and an inner wall of the TGV and is in contact with the substrate, so that the substrate can be led to a surface of the semiconductor device. The protective layer can cover the connecting piece, so that the connecting piece is not affected when a TGV process is performed, to ensure a good conductive effect, thereby causing no impact on performance of the device.

Specifically, a single-layer structure or a multi-layer structure may be selected for the protective layer. In specific implementation, adaptive selection may be performed based on an application scenario. A material of the protective layer may be one or a combination of several of W, Ti, Ti/TiN, Al/Ti/TiN, and a polycrystalline silicon doped conductive material, and a thickness of the protective layer may be 100 A to 2000 A, thereby causing no impact on an electrical connection effect between the first metal layer and the second metal layer.

In addition, the connecting material may be one or a combination of a plurality of Ti, TiN, W, TiW, and Ni. A material of the substrate may be SiC, a Si-based semiconductor material, or a III-V group compound. A material of the first metal layer may be one or a combined laminated layer of a plurality of Al, AlCu, AlSiCu, TiN, W, Ni, Ta, TaN, Pd, WSi, and metal compounds thereof, and/or a material of the second metal layer may be one or a combined laminated layer of a plurality of Al, AlCu, AlSiCu, TiN, W, Ni, Ta, TaN, Pd, WSi, and metal compounds thereof.

In some possible implementations, an isolation structure such as a trench or a notch is disposed in the second metal layer, and the isolation structure is used to divide the second metal layer into different regions (for example, a gate region, a source region, and a drain region) to implement different functions.

According to a second aspect, this application further provides a preparation method of a semiconductor device, used to prepare the semiconductor device in the foregoing technical solution. The method includes the following steps:
sequentially forming an epitaxial layer, a first dielectric layer, a first metal layer, and a second dielectric layer on a substrate, where the substrate has a first region and a second region, and the first metal layer corresponds to the first region;
forming, in the second dielectric layer, through vias that penetrate through the second dielectric layer to the first metal layer, and filling a connecting material in the through via to form a connecting piece;
forming a protective layer on a side that is of the second dielectric layer and that is far away from the substrate, to cover the second dielectric layer and a surface of the connecting piece;
etching the protective layer, the second dielectric layer, the first dielectric layer, and the epitaxial layer to the substrate in the second region, to form a through gallium nitride via TGV; and
depositing metal on a side that is of the protective layer and that is far away from the substrate, to form a second metal layer that covers the protective layer, where the second metal layer covers an inner wall of the TGV and is in contact with the substrate.

In some possible implementations, after the second metal layer is formed, the method further includes the following step:
patterning the second metal layer to divide the second metal layer into different functional regions.

### BRIEF DESCRIPTION OF DRAWINGS

FIG. 1a is a schematic diagram of a structure of a semiconductor device according to the conventional technology;
FIG. 1b to FIG. 1d are schematic diagrams of a preparation process of a semiconductor device according to the conventional technology;
FIG. 2a and FIG. 2b are schematic diagrams of a structure of a semiconductor device according to an embodiment of this application;
FIG. 3 is a schematic diagram of a structure of a protective layer in a semiconductor device according to an embodiment of this application;
FIG. 4a to FIG. 4c are schematic diagrams of structures of a protective layer in a semiconductor device according to an embodiment of this application;
FIG. 5 is a schematic diagram of a through via resistance test effect of a semiconductor device according to an embodiment of this application;
FIG. 6 is a schematic flowchart of a preparation method of a semiconductor device according to an embodiment of this application;
FIG. 7a to FIG. 7d are schematic diagrams of a structural change of a semiconductor device in a preparation process according to an embodiment of this application; and
FIG. 8 is a schematic diagram of a structure of a semiconductor device with a notch in a preparation process according to an embodiment of this application.

### DESCRIPTION OF EMBODIMENTS

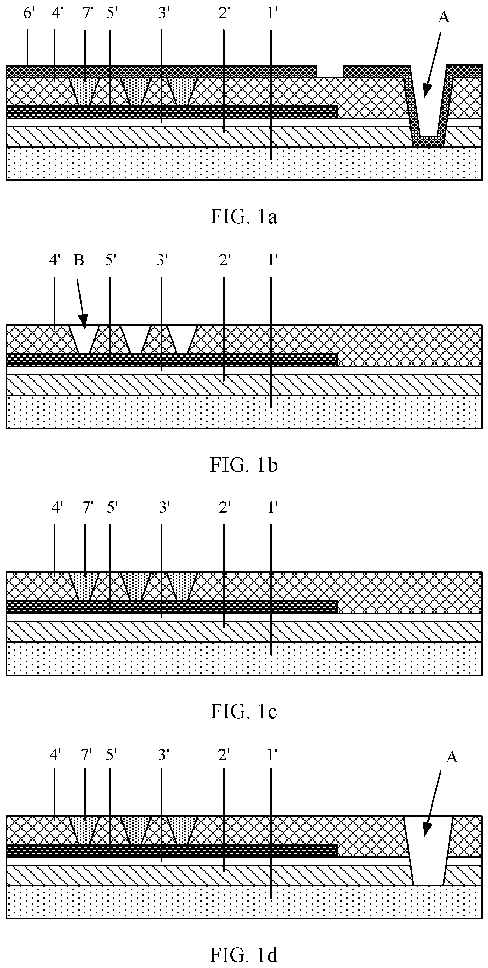

Currently, a TGV is usually made in a semiconductor device, to reduce structural damage caused by different expansion coefficients of an epitaxial structure and a substrate structure in a preparation process. For example, FIG. 1a shows a semiconductor device, namely, a HEMT device, commonly used in the industry. The HEMT device specifically includes a substrate 1', and an epitaxial layer 2', a first dielectric layer 3', and a second dielectric layer 4' that are sequentially disposed on the substrate 1'. A first metal layer 5' is disposed between the first dielectric layer 3' and the second dielectric layer 4', and a projection area of the first metal layer 5' on the first dielectric layer 3' corresponds to a functional region of the HEMT device. The HEMT device has a TGV A that penetrates through the second dielectric layer 4', the first dielectric layer 3', and the epitaxial layer 2' to the underlying layer 1'. A second metal layer 6' is disposed on a surface of the second dielectric layer 4', and the second metal layer 6' also covers the TGV A. Tungsten plugs 7' are disposed in the second dielectric layer 4'. The tungsten plug 7' is tapered, and penetrates from a surface that is of the second dielectric layer 4' and that faces the second metal layer 6' to a surface that is of the second dielectric layer 4' and that faces the first metal layer 5', to implement electrical connection between the first metal layer 5' and the second metal layer 6'. In a preparation process of the semiconductor device, first, as shown in FIG. 1b, through vias B are formed in the second dielectric layer 4' by using photolithography and etching processes; then, as shown in FIG. 1c, tungsten is deposited in the through via B through chemical vapor deposition (CVD), and tungsten outside the through via B is etched back, to form the tungsten plug 7', where the tungsten plug 7' abuts against the first metal layer 5'; then, a TGV process is performed, specifically including process steps such as glue spreading, exposure, development, etching, and glue removal, to form the TGV A shown in FIG. 1d; and finally, a layer of metal is sputtered and deposited through physical vapor deposition (PVD) to form the second metal layer 6' (for a structure, refer to FIG. 1a), and the second metal layer 6' is photolithographed and etched, so that metal in the TGV A can be led out, thereby facilitating packaging wiring connection. In this HEMT device, tungsten at a middle position of the tungsten plug 7 has relatively poor filling morphology and quality, and the tungsten plug 7 is V-shaped and therefore it is prone to remain photoresist and other substances when the subsequent TGV process is performed, finally resulting in an increase in a contact resistance of the through via B, affecting overall performance of the device.

Based on this, embodiments of this application provide a semiconductor device and a preparation method thereof, to resolve the foregoing problem. To make the objectives, technical solutions, and advantages of this application clearer, the following further describes this application in detail with reference to the accompanying drawings.

Terms used in the following embodiments are merely intended to describe specific embodiments, but are not intended to limit this application. The terms "one", "a" and "this" of singular forms used in this specification and the appended claims of this application are also intended to include expressions such as "one or more", unless otherwise specified in the context clearly.

Reference to "an embodiment", "some embodiments", or the like in this specification means that a particular feature, structure, or characteristic described with reference to the embodiment is included in one or more embodiments of this application. Therefore, statements such as "in an embodiment", "in some embodiments", "in some other embodiments", and "in other embodiments" that appear at different places in this specification do not necessarily mean referring to a same embodiment. Instead, the statements mean "one or more but not all of embodiments", unless otherwise specifically emphasized in another manner. The terms "include", "have", and their variants all mean "include but are not limited to", unless otherwise specifically emphasized in another manner.

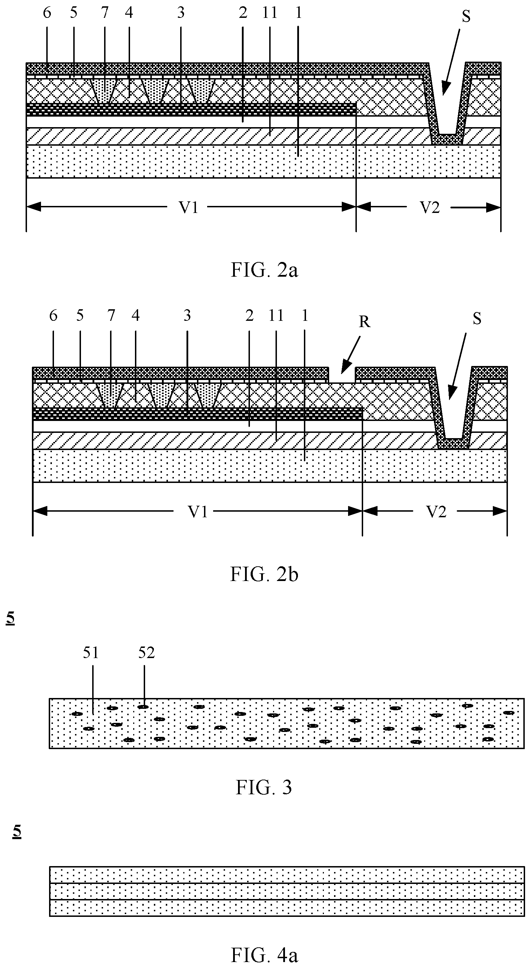

Refer to FIG. 2a. An embodiment of this application provides a semiconductor device. The semiconductor device includes a substrate 1, and an epitaxial layer 11, a first dielectric layer 2, a first metal layer 3, a second dielectric layer 4, a protective layer 5, and a second metal layer 6 that are sequentially laminated on the substrate 1 from bottom to top. Based on functional use division of the semiconductor device, the semiconductor device has a first region V1 and a second region V2. The first region V1 corresponds to a region in which a functional device in the semiconductor device is located, and the second region V2 is equivalent to a region other than the region in which the functional device in the semiconductor device is located. The first metal layer 3 is correspondingly disposed in the first region V1, in other words, the first metal layer 3 does not exist in the second region V2. In the second region V2, the first dielectric layer 2 is in direct contact with the second dielectric layer 4. The second dielectric layer 4 has through vias that penetrate through the second dielectric layer 4 to connect the first metal layer 3 and the protective layer 5 A connecting material is filled in the through via to form a connecting piece 7. The connecting piece 7 is equivalent to a conductor for connecting the first metal layer 3 and the second metal layer 6. A shape of the connecting piece 7 adapts to a shape of the through via, and is a circular table shape with a large end and a small end. The small-sized end of the connecting piece 7 is in contact with the first metal layer 3, and the large-sized end of the connecting piece 7 is in contact with the second metal layer 6. The second region V2 has a TGV S. The TGV S penetrates through the protective layer 5, the second dielectric layer 4, the first dielectric layer 2, and the epitaxial layer 11 to the substrate 1, and the substrate 1 is exposed. The second metal layer 6 covers the protective layer 5 and the TGV S, so that metal of the substrate 1 exposed from the TGV S can be led out, thereby facilitating subsequent packaging wiring. The epitaxial layer 11 may be grown from the substrate 1 during preparation.

The protective layer 5 covers the second dielectric layer 4 and the connecting piece 7, and a surface of the connecting piece 7 is protected from being affected when the TGV S is subsequently prepared. Therefore, a contact resistance of the connecting piece 7 is maintained without being affected to decrease, thereby causing no adverse impact on performance of the semiconductor device.

Refer to FIG. 2b. In some embodiments, an isolation structure R that penetrates through the second metal layer 6 and the protective layer 5 to the second dielectric layer 4 may be further disposed in the semiconductor device provided in this embodiment of this application. The isolation structure R corresponds to the first region V1, and can divide the second metal layer 6 into different regions. The different regions of the second metal layer 6 may be used to implement different functions. For example, the second metal layer 6 may be divided into a gate region, a source region, and a drain region. The isolation structure R may be a trench shown in FIG. 2b, or may be another structure. Details are not described herein.

A material of the protective layer 5 may be specifically one or a combination of several of W, Ti, Ti/TiN, Al/Ti/TiN, and a polycrystalline silicon doped conductive material, and a thickness of the protective layer 5 is selected as 100 A to 2000 A. The connecting material used to form the connecting piece 7 may be one or a combination of a plurality of Ti, TiN, W, TiW, and Ni, where W is a relatively common material. A material of the substrate 1 may be SiC, a Si-based semiconductor material, or a III-V group compound.

A material of the first metal layer 3 may be one or a combined laminated layer of a plurality of Al, AlCu, AlSiCu, TiN, W, Ni, Ta, TaN, Pd, WSi, and metal compounds thereof; and/or a material of the second metal layer 6 may be one or a combined laminated layer of a plurality of Al, AlCu, AlSiCu, TiN, W, Ni, Ta, TaN, Pd, WSi, and metal compounds thereof.

Herein, if the solution described in front of "and/or" is set to a solution a, and the solution described behind "and/or" is set to a solution b, the foregoing technical solution includes three implementations: Both the solution a and the solution b are implemented, only the solution a is implemented, and only the solution b is implemented. In a specific application scenario, adaptive selection may be performed based on the application scenario.

In some embodiments, a structure of the protective layer 5 may be a single-layer structure; and specifically, may be a single-layer structure (not shown in a figure herein) of one type of material, or may be a structure that is shown in FIG. 3 and that is obtained after at least one type of dopant 52 is doped in a matrix 51.

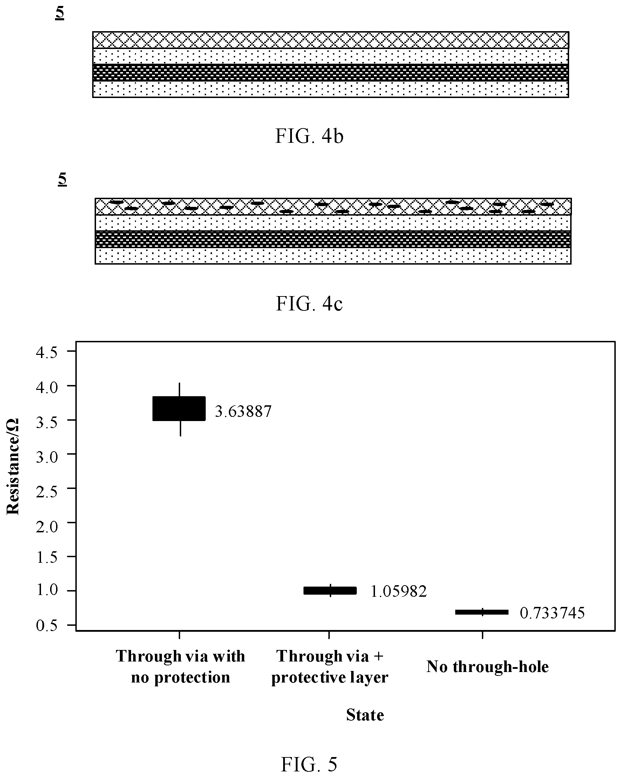

In some other embodiments, a structure of the protective layer 5 may be a multi-layer structure; and specifically, may be formed by laminating a plurality of single-layer structures of a same type of material as shown in FIG. 4a, or may be formed by laminating single-layer structures of at least two types of different materials as shown in FIG. 4b. Certainly, in the protective layer 5 of the multi-layer structure, as shown in FIG. 4c, a single-layer structure of a layer may be a structure that is shown in FIG. 3 and that is obtained after at least one type of dopant 52 is doped in a matrix 51.

A test result shown in FIG. 5 may be obtained by performing batch test simulation on contact resistances of different through via processes, where horizontal coordinates are different process states, and vertical coordinates are through via resistances. For a "through via with no protection" structure, refer to the existing semiconductor device shown in FIG. 1a. A resistance value of the through via B (a position at which the connecting piece 7' is located) of the semiconductor device approximately ranges between 3.5 Ω and 3.9 Ω, and 3.63887 Ω is a median value of the resistance of the through via B in this semiconductor device, that is, 50% of resistances of the through vias B are greater than the resistance value. A "through via + protective layer" structure is the semiconductor device provided in this embodiment of this application (refer to FIG. 2a). A resistance value of the through via M (a position at which the connecting piece 7 is located) of the semiconductor device approximately ranges between 1 Ω and 1.2 Ω, and 1.05982 Ω is a median value of the resistance of the through via Min this semiconductor device, that is, 50% of resistances of the through vias M are greater than the resistance value. A resistance value in a "no through via" structure approximately ranges between 0.7 Ω and 0.8 Ω, and 0.733745 Ω is a median value of a resistance between two metal layers in this semiconductor device, that is, 50% of resistances between the two metal layers are greater than the resistance value. It may be learned that, compared with the "through via with no protection" semiconductor device (the structure shown in FIG. 1a), in the semiconductor device provided in this embodiment of this application, due to existence of the protective layer 5, the resistance of the through via M (the position at which the connecting piece 7 is located) between the first metal layer 3 and the second metal layer 6 can be significantly reduced, and even less than one third of the resistance of the through via B in the "through via with no protection" semiconductor device, and slightly different from the resistance between the two metal layers in the "no through via" semiconductor device, thereby achieving a good current conduction effect and reducing energy consumption.

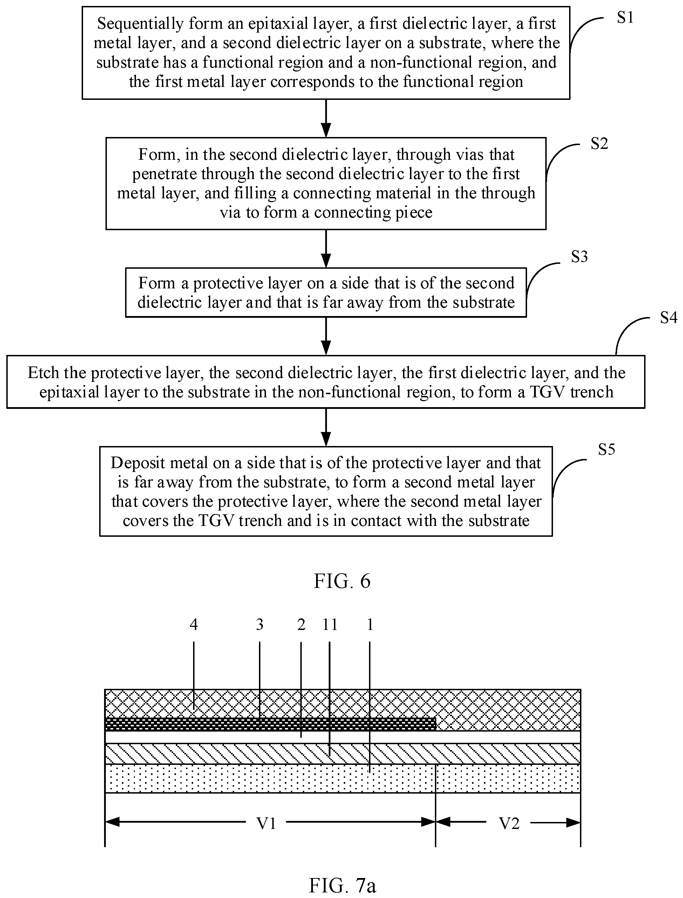

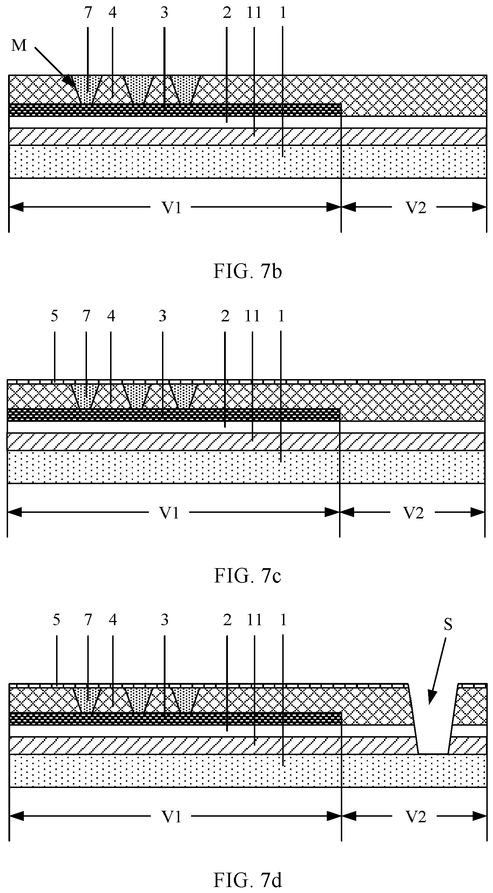

Based on the semiconductor device, an embodiment of this application further provides a preparation method used to prepare a semiconductor device. As shown in FIG. 6, the method specifically includes the following steps:
Step S1: Sequentially form an epitaxial layer 11, a first dielectric layer 2, a first metal layer 3, and a second dielectric layer 4 on a substrate 1, to obtain a structure shown in FIG. 7a, where the substrate 1 has a first region V1 and a second region V2, and the first metal layer 3 corresponds to the first region V1.
Step S2: Form, in the second dielectric layer 4, through vias M that penetrate through the second dielectric layer 4 to the first metal layer 3, and filling a connecting material in the through via M to form a connecting piece 7, to obtain a structure shown in FIG. 7b.
   Specifically, glue is spread on the second dielectric layer 4, and exposure, development, and baking are performed by using a first template, to obtain the through via M. Then, a layer of connecting material is deposited, through chemical deposition, on a side that is of the second dielectric layer 4 and that is far away from the substrate 1, and another connecting material outside the through via is etched back, so that the connecting material is remained only in the through via M to form the connecting piece 7. The connecting material may be one or a combination of a plurality of Ti, TiN, W, TiW, and Ni.
Step S3: Form a protective layer 5 on the side that is of the second dielectric layer 4 and that is far away from the substrate 1, to obtain a structure shown in FIG. 7c.
   A material of the protective layer 5 may be selected as one or a combination of several of W, Ti, Ti/TiN, Al/Ti/TiN, and a polycrystalline silicon doped conductive material, and a thickness of the protective layer 5 is selected as 100 A to 2000 A.
Step S4: Etch the protective layer 5, the second dielectric layer 4, the first dielectric layer 2, and the epitaxial layer 11 to the substrate 1 in the second region V2, to form a TGV S.
   Specifically, glue is spread on the protective layer 5, exposure, development, and baking are performed by using a second template, and the protective layer 5, the second dielectric layer 4, the first dielectric layer 2, and the epitaxial layer 11 are etched to the substrate 1, to obtain the TGV S. Remaining photoresist and etching by-products may be removed by using a dry + wet mixing process, to obtain a structure shown in FIG. 7d.
Step S5: Deposit metal on a side that is of the protective layer 5 and that is far away from the substrate 1, to form a second metal layer 6 that covers the protective layer 5, where the second metal layer 6 covers an inner wall of the TGV S and is in contact with the substrate 1.

Specifically, the metal is grown on the side that is of the protective layer 5 and that is far away from the substrate 1 and in the TGV S through physical vapor deposition to obtain the second metal layer 6, to finally obtain the semiconductor device shown in FIG. 2a. A material of the second metal layer 6 includes but is not limited to one or a combined laminated layer of a plurality of Al, AlCu, AlSiCu, TiN, W, Ni, Ta, TaN, Pd, WSi, and metal compounds

After step S5 is implemented, to form a pattern on the second metal layer 6, glue may be spread on the second metal layer 6, exposure, development, and baking may be performed by using a third template, the second metal layer 6 may be etched by using a dry method, and finally photoresist and etching by-products may be removed.

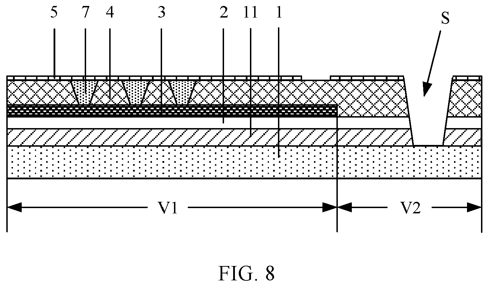

In some embodiments, if the semiconductor device that is shown in FIG. 2b and that has the isolation structure R needs to be obtained, after the structure shown in FIG. 2a is obtained, the second metal layer 6 and the protective layer 5 may be directly etched by using a template, to obtain the semiconductor device shown in FIG. 2b. Alternatively, after the structure shown in FIG. 7d is obtained, the protective layer 5 is etched to obtain a structure shown in FIG. 8; and then, after the second metal layer 6 is obtained by depositing the metal on the side that is of the protective layer 5 and that is far away from the substrate 1, the second metal layer 6 is etched to obtain the semiconductor device shown in FIG. 2b. The isolation structure R can divide the second metal layer 6 into different functional regions (for example, a gate region, a source region, and a drain region) to implement different functions.

The semiconductor device provided in this embodiment of this application has the TGV, so that structural deformation caused by different expansion coefficients of an epitaxial structure and a substrate structure can be alleviated. Because there is the protective layer 5 on the side that is of the second dielectric layer 4 and that is far away from the substrate 1, the protective layer 5 can reduce impact of the TGV process on the through via resistance, thereby ensuring overall performance of the semiconductor device.

The foregoing descriptions are merely specific implementations of this application, but are not intended to limit the protection scope of this application. Therefore, the protection scope of this application shall be subject to the protection scope of the claims.

## Claims

1. A semiconductor device, wherein the semiconductor device has a first region (V1) and a second region (V2), the second region has a through gallium nitride via TGV
(S), and the semiconductor device comprises a substrate (1), and an epitaxial layer (11), a first dielectric layer (2), a first metal layer (3), a second dielectric layer (4), a protective layer (5), and a second metal layer (6) that are sequentially laminated on the substrate (1);
the first metal layer (3) is located in the first region (V1), the second dielectric layer (4) has through vias that penetrate through the second dielectric layer (4) to connect the first metal layer (3) and the protective layer (5), and a connecting material is filled in the through via to form a connecting piece (7), wherein the protective layer (5) covers a surface of the connecting piece (7); and
the TGV (S) penetrates through the protective layer (5), the second dielectric layer (4), the first dielectric layer (2), and the epitaxial layer (11) to the substrate (1), and the second metal layer (6) covers the protective layer (5) and an inner wall of the TGV (S) and is in contact with the substrate (1).

2. The semiconductor device according to claim 1, wherein a material of the protective layer (5) is one or a combination of several of W, Ti, Ti/TiN, Al/Ti/TiN, and a polycrystalline silicon doped conductive material.

3. The semiconductor device according to claim 1 or 2, wherein a thickness of the protective layer (5) is 100 A to 2000 A.

4. The semiconductor device according to any one of claims 1 to 3, wherein the protective layer (5) has a single-layer or multi-layer structure.

5. The semiconductor device according to any one of claims 1 to 4, wherein the connecting material is one or a combination of a plurality of Ti, TiN, W, TiW, and Ni.

6. The semiconductor device according to any one of claims 1 to 5, wherein a material of the substrate (1) is SiC, a Si-based semiconductor material, or a III-V group compound.

7. The semiconductor device according to any one of claims 1 to 6, wherein a material of the first metal layer (3) is one or a combined laminated layer of a plurality of Al, AlCu, AlSiCu, TiN, W, Ni, Ta, TaN, Pd, WSi, and metal compounds thereof, and/or
a material of the second metal layer (6) is one or a combined laminated layer of a plurality of Al, AlCu, AlSiCu, TiN, W, Ni, Ta, TaN, Pd, WSi, and metal compounds thereof.

8. The semiconductor device according to any one of claims 1 to 7, wherein the semiconductor device further has an isolation structure (R) that penetrates through the second metal layer (6) and the protective layer (5) to the second dielectric layer (4), to divide the second metal layer (6) into different regions.

9. A preparation method of a semiconductor device, used to prepare the semiconductor device according to any one of claims 1 to 8, and the method comprises the following steps:
sequentially forming an epitaxial layer (11), a first dielectric layer (2), a first metal layer (3), and a second dielectric layer (4) on a substrate (1), wherein the substrate (1) has a first region (V1) and a second region (V2), and the first metal layer (3) corresponds to the first region (V1);
forming, in the second dielectric layer (4), through vias that penetrate through the second dielectric layer (4) to the first metal layer (3), and filling a connecting material in the through via to form a connecting piece;
forming a protective layer (5) on a side that is of the second dielectric layer (4) and that is far away from the substrate (1), to cover the second dielectric layer (4) and a surface of the connecting piece (7);
etching the protective layer (5), the second dielectric layer (4), the first dielectric layer (2), and the epitaxial layer (11) to the substrate (1) in the second region (V2), to form a through gallium nitride via TGV (S); and
depositing metal on a side that is of the protective layer (5) and that is far away from the substrate (1), to form a second metal layer (6) that covers the protective layer (5), wherein the second metal layer (6) covers an inner wall of the TGV (S) and is in contact with the substrate (1).

10. The preparation method according to claim 9, wherein after the second metal layer (6) is formed, the method further comprises:
patterning the second metal layer (6) to divide the second metal layer (6) into different regions.

## Patentansprüche

1. Halbleitervorrichtung, wobei die Halbleitervorrichtung einen ersten Bereich (V1) und einen zweiten Bereich (V2) aufweist, der zweite Bereich eine Galliumnitrid-Durchkontaktierung TGV (S) aufweist und die Halbleitervorrichtung ein Substrat (1) und eine Epitaxieschicht (11), eine erste dielektrische Schicht (2), eine erste Metallschicht (3), eine zweite dielektrische Schicht (4), eine Schutzschicht (5) und eine zweite Metallschicht (6), die nacheinander auf dem Substrat (1) laminiert sind, umfasst;
die erste Metallschicht (3) sich in dem ersten Bereich (V1) befindet, die zweite dielektrische Schicht (4) Durchkontaktierungen aufweist, die die zweite dielektrische Schicht (4) durchdringen, um die erste Metallschicht (3) und die Schutzschicht (5) zu verbinden, und ein Verbindungsmaterial in die Durchkontaktierung gefüllt ist, um ein Verbindungsstück (7) zu bilden, wobei die Schutzschicht (5) eine Oberfläche des Verbindungsstücks (7) bedeckt; und
das TGV (S) die Schutzschicht (5), die zweite dielektrische Schicht (4), die erste dielektrische Schicht (2) und die Epitaxieschicht (11) bis zum Substrat (1) durchdringt, und die zweite Metallschicht (6) die Schutzschicht (5) und eine Innenwand des TGV (S) bedeckt und in Kontakt mit dem Substrat (1) steht.

2. Halbleitervorrichtung nach Anspruch 1, wobei ein Material der Schutzschicht (5) eines oder eine Kombination mehrerer von W, Ti, Ti/TiN, Al/Ti/TiN und einem mit polykristallinem Silizium dotierten leitfähigen Material ist.

3. Halbleitervorrichtung nach Anspruch 1 oder 2, wobei eine Dicke der Schutzschicht (5) 100 A bis 2000 A beträgt.

4. Halbleitervorrichtung nach einem der Ansprüche 1 bis 3, wobei die Schutzschicht (5) eine einschichtige oder mehrschichtige Struktur aufweist.

5. Halbleitervorrichtung nach einem der Ansprüche 1 bis 4, wobei das Verbindungsmaterial eines oder eine Kombination aus einer Vielzahl von Ti, TiN, W, TiW und Ni ist.

6. Halbleitervorrichtung nach einem der Ansprüche 1 bis 5, wobei ein Material des Substrats (1) SiC, ein Si-basiertes Halbleitermaterial oder eine Verbindung der III-V-Gruppe ist.

7. Halbleitervorrichtung nach einem der Ansprüche 1 bis 6, wobei ein Material der ersten Metallschicht (3) eines oder eine kombinierte laminierte Schicht aus einer Vielzahl von Al, AlCu, AlSiCu, TiN, W, Ni, Ta, TaN, Pd, WSi und Metallverbindungen davon ist; und/oder ein Material der zweiten Metallschicht (6) eines oder eine kombinierte laminierte Schicht aus einer Vielzahl von Al, AlCu, AlSiCu, TiN, W, Ni, Ta, TaN, Pd, WSi und Metallverbindungen davon ist.

8. Halbleitervorrichtung nach einem der Ansprüche 1 bis 7, wobei die Halbleitervorrichtung ferner eine Isolationsstruktur (R) aufweist, die die zweite Metallschicht (6) und die Schutzschicht (5) bis zu der zweiten dielektrischen Schicht (4) durchdringt, um die zweite Metallschicht (6) in verschiedene Bereiche zu unterteilen.

9. Herstellungsverfahren für eine Halbleitervorrichtung, die zur Herstellung der Halbleitervorrichtung nach einem der Ansprüche 1 bis 8 verwendet wird, und das Verfahren umfasst die folgenden Schritte:
aufeinanderfolgendes Bilden einer Epitaxieschicht (11), einer ersten dielektrischen Schicht (2), einer ersten Metallschicht (3) und einer zweiten dielektrischen Schicht (4) auf einem Substrat (1), wobei das Substrat (1) einen ersten Bereich (V1) und einen zweiten Bereich (V2) aufweist und die erste Metallschicht (3) dem ersten Bereich (V1) entspricht;
Bilden von Durchkontaktierungen in der zweiten dielektrischen Schicht (4), die die zweite dielektrische Schicht (4) bis zu der ersten Metallschicht (3) durchdringen, und Füllen eines Verbindungsmaterials in die Durchkontaktierung, um ein Verbindungsstück zu bilden;
Bilden einer Schutzschicht (5) auf einer Seite der zweiten dielektrischen Schicht (4), die weit von dem Substrat (1) entfernt ist, um die zweite dielektrische Schicht (4) und eine Oberfläche des Verbindungsstücks (7) zu bedecken;
Ätzen der Schutzschicht (5), der zweiten dielektrischen Schicht (4), der ersten dielektrischen Schicht (2) und der Epitaxieschicht (11) bis zu dem Substrat (1) in dem zweiten Bereich (V2), um eine Galliumnitrid-Durchkontaktierung TGV (S) zu bilden; und
Abscheiden von Metall auf einer Seite der Schutzschicht (5), die weit von dem Substrat (1) entfernt ist, um eine zweite Metallschicht (6) zu bilden, welche die Schutzschicht (5) bedeckt, wobei die zweite Metallschicht (6) eine Innenwand des TGV (S) bedeckt und in Kontakt mit dem Substrat (1) steht.

10. Herstellungsverfahren nach Anspruch 9, wobei, nachdem die zweite Metallschicht (6) gebildet wurde, das Verfahren ferner umfasst:
Strukturieren der zweiten Metallschicht (6), um die zweite Metallschicht (6) in verschiedene Bereiche zu unterteilen.

## Revendications

1. Dispositif à semi-conducteur, dans lequel le dispositif à semi-conducteur a une première région (V1) et une seconde région (V2), la seconde région a un trou d'interconnexion traversant du nitrure de gallium, TGV (S), et le dispositif à semi-conducteur comprend un substrat (1), et une couche épitaxiale (11), une première couche diélectrique (2), une première couche métallique (3), une seconde couche diélectrique (4), une couche protectrice (5) et une seconde couche métallique (6) qui sont stratifiées séquentiellement sur le substrat (1) ;
la première couche métallique (3) est située dans la première région (V1), la seconde couche diélectrique (4) a des trous d'interconnexion traversants qui pénètrent à travers la seconde couche diélectrique (4) pour relier la première couche métallique (3) et la couche protectrice (5), et un matériau de liaison est rempli dans le trou d'interconnexion traversant pour former une pièce de liaison (7), dans lequel la couche protectrice (5) recouvre une surface de la pièce de liaison (7) ; et
le TGV (S) pénètre à travers la couche protectrice (5), la seconde couche diélectrique (4), la première couche diélectrique (2) et la couche épitaxiale (11) jusqu'au substrat (1), et la seconde couche métallique (6) recouvre la couche protectrice (5) et une paroi interne du TGV (S) et est en contact avec le substrat (1).

2. Dispositif à semi-conducteur selon la revendication 1, dans lequel un matériau de la couche protectrice (5) est l'un ou une combinaison de plusieurs parmi W, Ti, Ti/TiN, Al/Ti/TiN, et un matériau conducteur dopé au silicium polycristallin.

3. Dispositif à semi-conducteur selon la revendication 1 ou 2, dans lequel une épaisseur de la couche protectrice (5) est de 100 A à 2000 A.

4. Dispositif à semi-conducteur selon l'une quelconque des revendications 1 à 3, dans lequel la couche protectrice (5) a une structure monocouche ou multicouche.

5. Dispositif à semi-conducteur selon l'une quelconque des revendications 1 à 4, dans lequel le matériau de liaison est l'un ou une combinaison d'une pluralité parmi Ti, TiN, W, TiW et Ni.

6. Dispositif à semi-conducteur selon l'une quelconque des revendications 1 à 5, dans lequel un matériau du substrat (1) est du SiC, un matériau semi-conducteur à base de Si, ou un composé de groupe III-V.

7. Dispositif à semi-conducteur selon l'une quelconque des revendications 1 à 6, dans lequel un matériau de la première couche métallique (3) est une couche ou une couche stratifiée combinée d'une pluralité parmi Al, AlCu, AlSiCu, TiN, W, Ni, Ta, TaN, Pd, WSi, et des composés métalliques de ceux-ci ; et/ou un matériau de la seconde couche métallique (6) est une couche ou une couche stratifiée combinée d'une pluralité parmi Al, AlCu, AlSiCu, TiN, W, Ni, Ta, TaN, Pd, WSi, et des composés métalliques de ceux-ci.

8. Dispositif à semi-conducteur selon l'une quelconque des revendications 1 à 7, dans lequel le dispositif à semi-conducteur a en outre une structure d'isolation (R) qui pénètre à travers la seconde couche métallique (6) et la couche protectrice (5) jusqu'à la seconde couche diélectrique (4), pour diviser la seconde couche métallique (6) en différentes régions.

9. Procédé de préparation d'un dispositif à semi-conducteur, utilisé pour préparer le dispositif à semi-conducteur selon l'une quelconque des revendications 1 à 8, et le procédé comprend les étapes suivantes :
la formation séquentielle d'une couche épitaxiale (11), d'une première couche diélectrique (2), d'une première couche métallique (3) et d'une seconde couche diélectrique (4) sur un substrat (1), dans lequel le substrat (1) a une première région (V1) et une seconde région (V2), et la première couche métallique (3) correspond à la première région (V1) ;
la formation, dans la seconde couche diélectrique (4), de trous d'interconnexion traversants qui pénètrent à travers la seconde couche diélectrique (4) jusqu'à la première couche métallique (3), et le remplissage d'un matériau de liaison dans le trou d'interconnexion traversant pour former une pièce de liaison ;
la formation d'une couche protectrice (5) sur un côté qui fait partie de la seconde couche diélectrique (4) et qui est éloigné du substrat (1), pour recouvrir la seconde couche diélectrique (4) et une surface de la pièce de liaison (7) ;
la gravure de la couche protectrice (5), de la seconde couche diélectrique (4), de la première couche diélectrique (2) et de la couche épitaxiale (11) sur le substrat (1) dans la seconde région (V2), pour former un trou d'interconnexion traversant du nitrure de gallium, TGV (S) ; et
le dépôt de métal sur un côté qui fait partie de la couche protectrice (5) et qui est éloigné du substrat (1), pour former une seconde couche métallique (6) qui recouvre la couche protectrice (5), dans lequel la seconde couche métallique (6) recouvre une paroi interne du TGV (S) et est en contact avec le substrat (1).

10. Procédé de préparation selon la revendication 9, dans lequel, après la formation de la seconde couche métallique (6), le procédé comprend en outre :
le modelage de la seconde couche métallique (6) pour diviser la seconde couche métallique (6) en différentes régions.
